Europäisches Patentamt

European Patent Office

Office européen des brevets

(11) Veröffentlichungsnummer: **0 301 306 B1**

(12) **EUROPÄISCHE PATENTSCHRIFT**

(45) Veröffentlichungstag der Patentschrift:
19.09.90

(21) Anmeldenummer: **88111106.6**

(22) Anmeldetag: **12.07.88**

(51) Int. Cl.⁵: **F17C 3/08**, F17C 13/08, H01F 7/22

(54) Kryostat und Verfahren zu seiner Montage.

(30) Priorität: **24.07.87 DE 3724562**

(43) Veröffentlichungstag der Anmeldung:
**01.02.89 Patentblatt 89/5**

(45) Bekanntmachung des Hinweises auf die Patenterteilung:
**19.09.90 Patentblatt 90/38**

(84) Benannte Vertragsstaaten:
**CH DE FR GB LI**

(56) Entgegenhaltungen:
**EP-A- 0 111 218**
**DE-A- 3 404 600**
**FR-A- 2 063 762**

**ADVANCES IN CRYOGENIC ENGINEERING,
Band 24, 1978, Seiten 283-289, Plenum Press, New York,
US; R.C. NIEMANN et al.: "An epoxy fiberglass tension
member support for superconducting magnets"**

(73) Patentinhaber: **Spectrospin AG, Industriestrasse 26,
CH-8117 Zürich-Fällanden(CH)**

(72) Erfinder: **Weber, Markus, Fällanderstrasse 4,
CH-8600 Dübendorf(CH)**
Erfinder: **Ryser, Andreas, Häglerstrasse 41,
CH-8600 Dübendorf(CH)**
Erfinder: **Jeker, René, Dr., Haldenweg 19,
CH-8634 Hombrechtikon(CH)**

(74) Vertreter: **Patentanwälte Kohler - Schwindling - Späth,
Hohentwielstrasse 41, D-7000 Stuttgart 1(DE)**

ACTORUM AG

## Beschreibung

Die Erfindung betrifft einen Kryostaten, insbesondere für supraleitende Magnete, mit ineinander geschachtelten, horizontal angeordneten, rohrförmigen Bauelementen, die an ihren Enden durch Deckel verschlossen sind und mindestens einen inneren und einen äußeren Tank zur Aufnahme eines Kühlmittels, einen zwischen den Tanks angeordneten Strahlungsschild und einen den äußeren Tank umgebenden Mantel bilden, von denen der innere und der äußere Tank an ihrer Oberseite jeweils ein radial nach außen ragendes und die nach außen anschließenden Bauelemente durchdringendes erstes bzw. zweites Rohr aufweisen, welche Rohre an der Außenseite des Mantels von einem auf den Mantel aufgesetzten Turm umgeben sind, und mit die Bauteile verbindenden Zugelementen.

Kryostaten der genannten Art sind allgemein bekannt. Insbesondere dann, wenn sie zur Aufnahme eines supraleitenden Magneten bestimmt sind und daher von einem zentralen Rohr durchsetzt werden, ist ihre Herstellung sehr kompliziert, weil jeweils das äußere Bauteil das innere vollständig umgeben muß und andererseits die Kühlmittel enthaltenden Gefäße radial nach außen führende Leitungen aufweisen müssen, welche die äußeren Bauelemente durchdringen. Diese Leitungen werden zum Einfüllen und Abdampfen der Kühlmittel sowie gegebenenfalls zum Herstellen elektrisch leitender Verbindungen zu der Spule des supraleitenden Magneten benötigt. Dieser Aufbau des Kryostaten hat bisher dazu geführt, daß der Kryostat stückweise von innen nach außen aufgebaut und aus Teilstücken zusammengeschweißt wurde. Anders besteht keine Möglichkeit, insbesondere die von dem inneren Kühlmitteltank nach außen führenden Rohre durch die äußeren Bauelemente hindurchzuführen. Dabei ist zu berücksichtigen, daß diese Rohre mit dem jeweiligen Tank vakuumdicht verbunden sein müssen, was vorzugsweise durch Schweißen geschieht, ein nachträgliches Einsetzen solcher Rohre aber nicht mehr möglich ist, weil dann die Verbindungsstellen zwischen dem Rohr und dem innen liegenden Tank nicht mehr zugänglich, sondern durch das äußere Bauteil abgedeckt ist. Die zum Zusammensetzen der einzelnen Bauteile erforderlichen Schweißarbeiten sind aber nicht nur sehr aufwendig, sondern verhindern auch die Anbringung einer durchgehenden Superisolierung zwischen den einzelnen Bauteilen. Ein weiterer Nachteil einer solchen Anordnung besteht darin, daß Reparaturen an einem solchen Kryostat nach seiner Fertigstellung praktisch nicht mehr möglich sind.

Demgemäß liegt der Erfindung die Aufgabe zugrunde, einen Kryo staten mit einem solchen Aufbau zu schaffen, daß eine Montage mit einem Minimum an Schweißarbeiten möglich ist und auch die Möglichkeit besteht, den Kryostaten nach seiner Fertigstellung zum Zwecke von Reparaturarbeiten wieder zu öffnen.

Diese Aufgabe wird nach der Erfindung dadurch gelöst, daß das erste Rohr nahe einem inneren Ende des inneren Tankes angeordnet ist, daß die zwischen dem inneren Tank und dem Mantel angeordneten Bauelemente an dem Ende, an dem sich das erste Rohr befindet, mit einem lösbaren Deckel versehen sind und eine bis zu diesem Ende des Bauelementes reichende Aussparung aufweisen, in die das erste Rohr bei fehlendem Deckel vom Ende des Bauelementes her einführbar ist, daß das zweite Rohr neben der Aussparung des äußeren Tankes angeordnet ist, daß der Mantel in einer den beiden Rohren benachbarten Ebene, die sich an der dem Ende des Mantels abgewandten Seite der Rohre befindet, in einen längeren und einen kürzeren Abschnitt unterteilt ist und der kürzere Abschnitt an seiner Umfangsfläche eine Öffnung für die den Mantel durchsetzenden Rohre aufweist und daß der die beiden Rohre umschließende Turm längs des Randes der Öffnung mit dem Mantel verbunden ist.

Die erfindungsgemäße Ausbildung des Kryostaten erlaubt es, die einzelnen Bauteile vor ihrer Montage im wesentlichen fertigzustellen, abgesehen von dem Anbringen des jeweils an einem Ende angeordneten, lösbaren Deckels, und gegebenenfalls zusammen mit einer Isolierschicht in das jeweilige äußere Bauteil einzusetzen bzw. über das innere Bauteil zu stülpen. Dabei läßt sich das von dem inneren Tank radial abstehende erste Rohr in die zu diesem Zweck in den äußeren Bauelementen vorgesehenen Aussparungen einführen, da diese Aussparungen zu den Enden dieser Bauelemente hin offen sind. Für die Deckel reicht es aus, wenn Sie mit den zugeordneten Bauteilen verschraubt werden, da auf diese Weise ein ausreichend guter Wärmekontakt herstellbar ist, eine vakuumdichte Verbindung jedoch nicht benötigt wird. Die Anordnung des zweiten Rohres neben der im äußeren Tank vorhandenen Aussparung hat zum Ergebnis, daß die beiden Rohre dicht neben einander angeordnet sind und daher in einem gemeinsamen Turm untergebracht werden können. Die Unterteilung des Mantels in der Weise, daß ein kurzer Abschnitt entsteht, der an seiner Umfangsfläche eine Aussparung für die den Mantel durchsetzenden Rohre aufweist, ermöglicht es, diesen kürzeren Abschnitt unter entsprechender Schrägstellung mit seiner Aussparung über die dicht nebeneinander angeordneten Rohre zu schieben und dann an das Ende des längeren Abschnittes anzusetzen. An der Außenseite des Mantels ist ausreichend Platz vorhanden, um hier Flansche vorzusehen, die eine vakuumdichte Schraubverbindung ermöglichen. Im Bereich des Turmes können dann gegebenenfalls Löt- und Schweißverbindungen hergestellt werden, die keine den Aufbau des Kryostaten beeinträchtigende Wärmeentwicklung zur Folge haben und auch leicht wieder aufgetrennt werden können, falls es erforderlich sein sollte, den Kryostaten wieder zu öffnen. Dabei besteht die Möglichkeit, in weiterer Ausgestaltung der Erfindung auf die Aussparung wenigstens eines der zwischen dem inneren Tank und dem Mantel angeordneten Bauelemente ein Kontaktrohr aufzusetzen, das mit wenigstens einem der diese Aussparung durchsetzenden Rohre in Wärmekontakt steht, um die Kühlwirkung des aus diesen Rohren abdampfenden Kühlmittels auszunutzen.

Die einfache Montierbarkeit des Kryostaten kann weiterhin dadurch gefördert werden, daß in weiterer Ausgestaltung der Erfindung die benachbarten Bauelemente durch Zugelemente miteinander verbunden sind, die an der Außenseite des jeweils inneren Bauelementes mittels Schrauben befestigt sind, die durch in der Wandung des jeweils äußeren Bauelementes angebrachte Aussparungen hindurch von außen zugänglich sind. Es können dann diese Zugelemente bereits vor der Montage der einzelnen Bauelemente an deren Innenseiten derart befestigt worden, daß ihr noch freies Ende einer zugeordneten Aussparung gegenüber liegt. Dann ist nach dem Einfügen des inneren Bauelementes in das äußere dieses Ende des Zugelementes zur Befestigung an dem inneren Bauelement zugänglich.

Für eine derartige Befestigung finden als Zugelemente vorzugsweise Zugstäbe Verwendung, die aus mit Glasfasergewebe verstärkten bandartigen Elementen bestehen, die an ihren Enden mit Bohrungen für die Festigungsschrauben versehe, verbreiterte Abschnitte aufweisen. Solche Zugelemente, die Gegenstand einer weiteren gleichrangigen Patentanmeldung sind, haben den besonderen Vorteil, daß sie zwischen den Bauelementen nur wenig Platz beanspruchen, einen gewissen seitlichen Versatz zwischen den Bauelementen zu überbrücken vermögen und endlich nur mit einer Schraube befestigbar sind. Eine solche Schraube kann vorteilhaft im Anschluß an ihren Kopf einen am zugeordneten Bauelement anschlagenden zylindrischen Abschnitt aufweisen, der als Lagerbolzen für den Zugstab dient, auf dem der Zugstab dann mit Spiel schwenkbar gelagert ist.

Endlich kann bei dem erfindungsgemäßen Kryostat am Ende des längeren Abschnittes des Mantels eine Anordnung zum Herstellen einer von außen lösbaren Verbindung zwischen dem Mantel und wenigstens dem inneren Tank angebracht sein. Eine solche Anordnung kann nicht nur als Transportsicherung dienen, sondern auch bei der Montage der erfindungsgemäßen Tankes nützlich sein.

Die Erfindung eignet sich auch für solche Kryostaten, die ein mit den Endwänden des Mantels verbundenes, zentrales Rohr aufweisen, das konzentrisch zu weiteren, mit den Deckeln der übrigen Bauteile verbundenen Rohren angeordnet ist. Gerade bei Kryomagneten umschließt ein solches zentrales Rohr den nutzbaren Bereich des von der supraleitenden Spule erzeugten Magnetfeldes. Bei einem solchen Kryostaten können die den übrigen Bauteilen zugeordneten Rohre einfach mit ihren Enden in zentrale Öffnungen eingreifen, die in den Deckeln der übrigen Bauteile angebracht sind, und mit diesen Deckeln durch geschlitzte Spannringe verbunden sein, die in die in den Deckeln angeordneten Öffnungen mit einer Kegelfläche eingreifen und die Rohre mit einer Zylinderfläche umschließen. Diese Spannringe können ohne weiteres an der Außenseite der Deckel angeordnet und mittels Schrauben mit den Deckeln verbunden sein, derart, daß durch Anziehen der Schrauben die Spannringe mit ihren Kegelflächen in die Öffnungen der Deckel hineingezogen und dadurch gleichzeitig fest an den Umfang der zu befestigenden Rohre angelegt werden. Auf diese Weise wird eine sehr stabile Fixierung erreicht und es kann zugleich für eine einwandfreie Zentrierung der Rohre Sorge getragen werden.

Bei der Anbringung des mit den Deckeln des Mantels verbundenen, auf Raumtemperatur liegenden Rohres ist es notwendig, eine vakuumdichte Verbindung zu den Deckeln herzustellen. Gleichzeitig dürfen die Verbindungsmittel den Innenraum des Rohres nicht verengen. Diese an sich schwierigen Forderungen können in überraschend einfacher Weise leicht dadurch erfüllt werden, daß auch dieses Rohr mit seinen Enden in entsprechende Öffnungen der Endwände eingreift, im Abstand von den Innenseiten der Endwände mit Anschlagringen versehen ist und zwischen den Anschlagringen und den Endwänden Dichtungsringe angeordnet sind, derart, daß das zentrale Rohr unter dem bei evakuiertem Kryostat auf dessen Mantel wirkenden Luftdruck allein von den über die Dichtungsringe an die Anschlagringe angepreßten Endwänden gehalten und abgedichtet wird. Hier werden also die bei größeren Kryostaten sehr beträchtlichen Kräfte ausgenutzt, die der Luftdruck bei evakuiertem Kryostaten auf dessen Endwände ausübt, um auf diese Weise die Spannkräfte zu erzeugen, durch die das zentrale Rohr sowohl sicher befestigt als auch einwandfrei abgedichtet wird. Daher werden keine aufwendigen und erheblichen Platz beanspruchenden Befestigungselemente benötigt. Auch werden hier wiederum Verbindungen vermieden, die nicht ohne weiteres wieder lösbar wären.

Die Erfindung hat auch ein Verfahren zum Montieren eines Kryostaten mit dem vorstehend beschriebenen Aufbau zum Gegenstand. Dieses Verfahren ist durch die folgenden Schritte gekennzeichnet:

a) Aufstellen des inneren Tankes mit vertikaler Achse und nach unten offenem Ende auf eine Lehre,

b) Aufstellen des Strahlungsschildes auf die Lehre in einer den inneren Tank übergreifenden Lage und Montieren der den inneren Tank mit dem Strahlungsschild verbindenden Zugstäbe

c) Montieren des das erste Rohr umgebenden Kontaktrohr am Strahlungsschild,

d) Aufstellen des äußeren Tankes auf die Lehre in einer den Strahlungsschild übergreifenden Lage und Montieren der den Strahlungsschild mit dem äußeren Tank verbindenden Zugstäbe,

e) Aufstellen des größeren Abschnittes des Mantels auf die Lehre in einer den äußeren Tank übergreifenden Lage und Montieren der den äußeren Tank mit dem Mantel verbindenden Zugstäbe,

f) Herstellen der lösbaren Verbindung zwischen dem Mantel und dem inneren Tank und Verschrauben des Mantels mit der Lehre,

g) Überführen der bisher montierten Anordnung in die horizontale Lage und Befestigen an einem Ständer,

h) Herstellen eines Wärmekontaktes zwischen dem am Strahlungsschild befestigten Kontaktrohr und dem ersten Rohr,

i) Befestigen des Kontaktrohres am äußeren Tank und Herstellen eines Wärmekontaktes zwischen diesem Kontaktrohr und dem ersten Rohr,

k) Montieren des Deckels des Strahlungsschil-

des und weiterer, den inneren Tank mit dem Strahlungsschild verbindender Zugstäbe,

l) Montieren des Deckels des äußeren Tanks und weiterer, den Strahlungsschild mit dem äußeren Tank verbindender Zugstäbe,

m) Ansetzen des kleineren Abschnittes des Mantels unter gleichzeitigem Einführen der beiden Rohre zusammen mit dem das erste Rohr umgebenden, am äußeren Tank befestigten Kontaktrohres in die Aussparung des kleineren Mantelteiles und Verschrauben der Mantelteile sowie Montieren weiterer, den äußeren Tank mit dem Mantel verbindender Zugstäbe,

n) Montieren des Turmes an der Außenseite des Mantels und Herstellen einer vakuumdichten Verbindung zwischen den Rohren der beiden Tanks und dem Turm und

o) Lösen der Verbindung zwischen dem inneren Behälter und dem Mantel.

Es ist ohne weiteres ersichtlich, daß bei diesem Verfahren jeweils die vollständig fertiggestellten und soweit erforderlich, mit Zugstäben versehenen und auch isolierten Bauelemente zusammengefügt werden können, ohne daß schwierig auszuführende sowie eine Isolation beiträchtigende Schweißarbeiten erforderlich sind. Lediglich die Wärmekontakte zwischen den Kontaktrohren und dem ersten Rohr werden vorzugsweise durch Löten und die vakuumdichte Verbindung zwischen dem Turm und dem ersten und dem zweiten Rohr wird vorzugsweise durch Schweißen her gestellt. Diese Löt- und Schweißstellen sind jedoch leicht zugänglich und auf einen sehr engen Raum begrenzt, so daß die hiervon ausgehende Wärmeentwicklung keinerlei schädliche Folgen hat. Auch kann es ohne weiteres in Kauf genommen werden, wenn bei einem notwendigen Öffnen des Kryostaten der außen am Mantel befestigte Turm aufgetrennt werden muß.

Die Erfindung wird im folgenden anhand in der Zeichnung dargestellten Ausführungsbeispieles näher beschrieben und erläutert. Die der Beschreibung und der Zeichnung zur entnehmenden Merkmale können bei anderen Ausführungsformen der Erfindung einzeln für sich oder zu mehreren in beliebiger Kombination Anwendung finden. Es zeigen

Fig. 1 Teilweise in Seitenansicht und teilweise im Schnitt einen Kryostaten nach der Erfindung,

Fig. 2 den in Fig. 1 rechten Abschnitt des Kryostaten in vergrößertem Maßstab,

Fig. 3 ein Detail der Fig. 2 in nochmals vergrößertem Maßstab,

Fig. 4 ein weiteres Detail des Kryostaten nach Fig. 1 in nochmals vergrößertem Maßstab, daß die Verbindung der Bauteile des Kryostaten nach Fig. 1 durch Zugstäbe veranschaulicht, und

Fig. 5 eine schematische Darstellung, welche die beim Zusammenbau des Kryostaten nach Fig. 1 erforderlichen Schritte veranschaulicht.

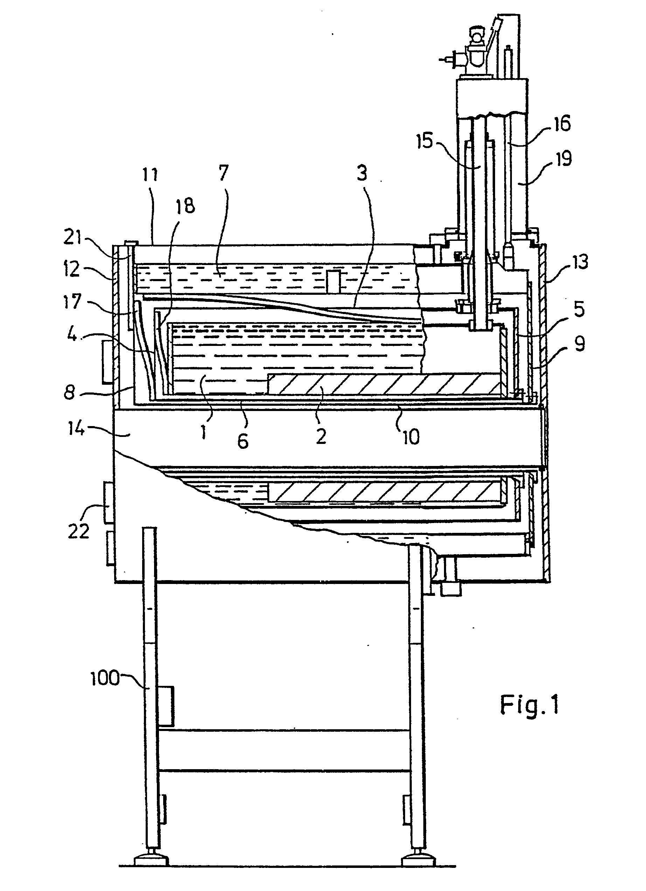

Der in den Fig. 1 bis 3 dargestellte Kryostat weist eine Anzahl rohrförmiger Bauelemente auf, die konzentrisch zueinander mit horizontaler Achse angeordnet sind. Es handelt sich dabei um einen nach Art eines doppelwandigen Rohres ausgebildeten Heliumtank 1, in dem eine supraleitende Spule 2 angeordnet ist. Der Heliumtank 1 wird mit Abstand von einem Strahlungsschild 3 umgeben, der an seinen Enden durch Deckel 4, 5 verschlossen ist, die weiterhin durch ein den Heliumtank 1 durchsetzendes, zentrales Rohr 6 miteinander verbunden sind.

Als nächstes Bauelement folgt nach außen ein Stickstofftank 7 der wiederum nach Art eines doppelwandigen Rohres ausgebildet ist. Dieses rohrförmige Bauteil ist an seinen Enden durch Deckel 8, 9 verschlossen, die jedoch wiederum im Bereich ihrer Mitte Öffnungen aufweisen, die durch ein zentrales Rohr 10 miteinander verbunden sind, welches das zentrale Rohr 6 des Strahlungsschildes 3 konzentrisch durchsetzt. Endlich sind die bisher beschriebenen Bauelemente von einem äußerem Mantel 11 umgeben, dessen Endwände 12, 13 wiederum Öffnungen aufweisen, die durch ein inneres zentrales Rohr 14 miteinander verbunden sind, das den Raum begrenzt, in dem sich der nutzbare Bereich des von der supraleitenden Spule 2 erzeugten Magnetfeldes befindet. Der innere Heliumtank 1 ist mit einem radial nach außen ragenden und bei der Anordnung der Bauelemente mit horizontaler Achse vertikal aufragenden ersten Rohr 15 versehen, welches das Befüllen des Haliumtankes 1 mit flüssigem Helium, das Abdampfen von Helium so wie auch in nicht näher dargestellter Weise des Herstellen einer elektrisch leitenden Verbindung zu der supraleitenden Spule 2 gestattet. Ein dem Befüllen mit Stickstoff und dem Abdampfen dieses Kühlmittels dienendes zweites Rohr 16 ist auch mit dem Stickstofftank 7 verbunden. Die einzelnen Bauelemente sind in der in Fig. 1 im wesentlichen schematisch dargestellten Weise durch Zugstäbe 17, 18 miteinander verbunden, die zwischen den Deckeln bzw. Endwänden der Bauteile angeordnet sind.

Der bisher beschriebene Aufbau des Kryostaten weicht vom Herkömmlichen nicht ab. Die Besonderheiten des beschriebenen Kryostaten bestehen darin, daß das vom Heliumtank 1 senkrecht aufragende, erste Rohre 15 unmittelbar an einem Ende des Heliumtankes angeordnet ist, und zwar an dem in der Zeichnung rechten Ende. Diese Maßnahme bietet die Möglichkeit, sowohl im Strahlungsschild 3 als auch im Stickstofftank 7 eine zum Ende des Strahlungsschildes bzw. des Stickstofftankes hin offene Aussparung 31 bzw. 71 vorzusehen, in die das erst Rohr 15 jeweils vom Ende her einschiebbar ist. Um ein solches Einschieben zu ermöglichen, sind die an diesen Enden des Strahlungsschildes 3 und des Stickstofftankes 7 angeordneten Deckel 5 bzw. 9 mit dem Strahlungsschild 3 bzw. dem Stickstofftank 7 lösbar verbunden, nämlich mittels Schrauben 32 bzw. 72 befestigt. Weiterhin ist auch das vom Stickstofftank ausgehende zweite Rohr 16 am Ende des Stickstofftankes in unmittelbarer Nachbarschaft zu dem mit dem Heliumtank 1 verbundenen ersten Rohr angeordnet, so daß beide Rohre 15, 16 in einen gemeinsamen Turm 19 aufgenommen werden können. Weiterhin ist der Mantel 11 in einer Ebene, die sich an der der Endwand 13 abgewandten Seite des Turmes 19 befindet, in einen längeren und einen kürzeren Abschnitt unterteilt. Im Bereich dieser Ebene sind die beiden Teile jeweils mit einem Flansch 41, 42 versehen, zwischen denen sich eine Dichtung 43 befindet und die durch Spannschrauben 44 zusammengehalten sind. Weiterhin ist auch der Turm 19 an dem kürzeren Mantelteil 45 lösbar befestigt, und zwar wiederum mittels eine Flanschanordnung 46 und von Spannschrauben 47. Die Länge des kürzeren Mantelteiles 45 entspricht dabei im wesentlichen dem Durchmesser der flanschanordnung 46 zur Befestigung des Turmes 19.

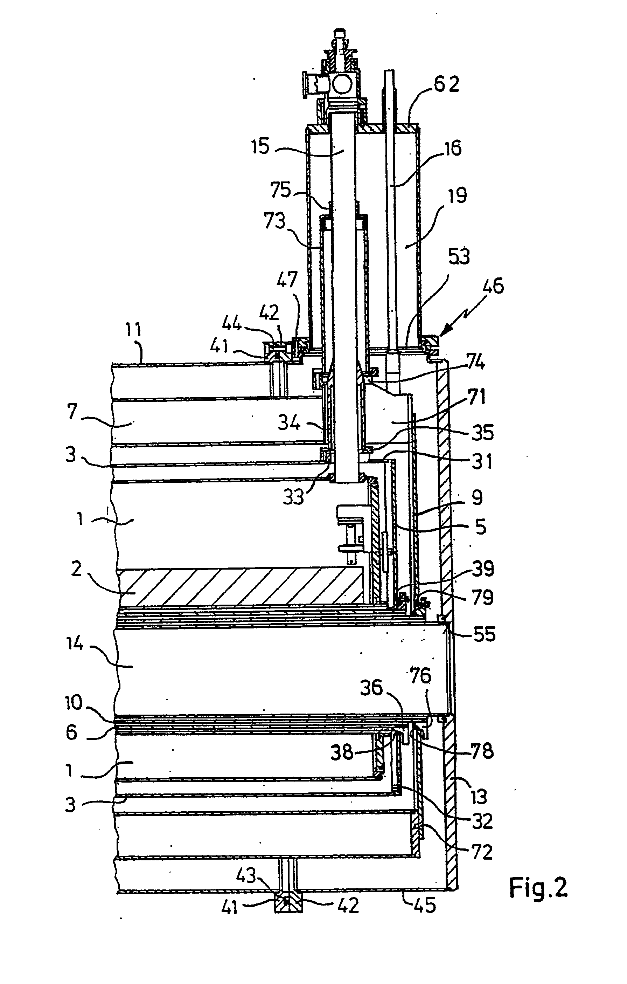

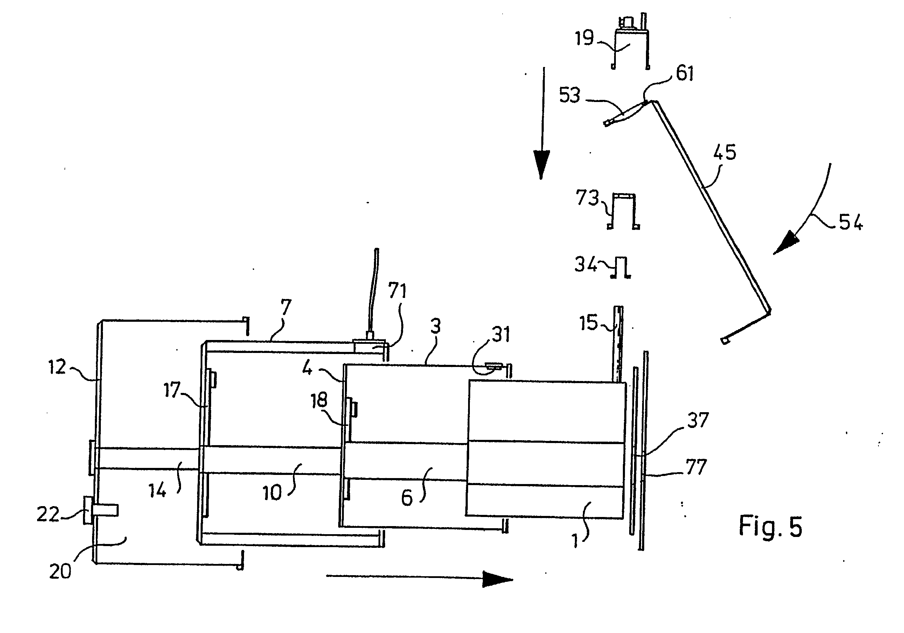

Wie in Fig. 5 schematisch dargestellt, läßt sich der Kryostat nach den Fig. 1 und 2 in der Weise montieren, daß zunächst der Heliumtank 1 in eine für die Montage geeignete Lage gebracht, nämlich mit vertikaler Achse auf einer Lehre aufgestellt wird, so daß sich das von dem Heliumrohr radial abstehende erste Rohr 15 am unter Ende des Tankes befindet. Dann wird der nur an einem Ende mit einem Deckel 4 versehene Strahlungsschild 3 zusammen mit dem im Deckel 4 befestigten zentralen Rohr 6 über den Heliumtank gestülpt, derart, daß die am offenen Ende des Strahlungsschildes 3 angeordnete Aussparung 31 das erste Rohr 15 aufnimmt. Der Rand dieser Aussparung hat einen verstärkten Abschnitt 33, der zum Befestigen eines Kontaktrohres 34 eingerichtet ist. Dieses Kontaktrohr 34 weist einen an dem verstärkten Abschnitt 33 anliegenden Schraubflansch 35 auf. Nachdem der Strahlungsschild in Bezug auf den Heliumtank 1 in die richtige Lage gebracht worden ist, wird das Kontaktrohr 34 auf das mit dem Heliumtank 1 verbundene erste Rohr 15 aufgeschoben und mit dem verstärkten Abschnitt 33 am Strahlungsschild 3 verschraubt.

Danach kann in gleicher Weise der Stickstofftank 7 mit dem zugeordneten, zentralen Rohr 10 aufgeschoben werden, wobei nun die Aussparung 71 am offenen Ende des Stickstofftankes das erste Rohr 15 mit dem aufgesetzten Kontaktrohr 34 aufnimmt. Anschließend wird der längere Mantelteil 20 mit dem zentralen Rohr 14 aufgesetzt.

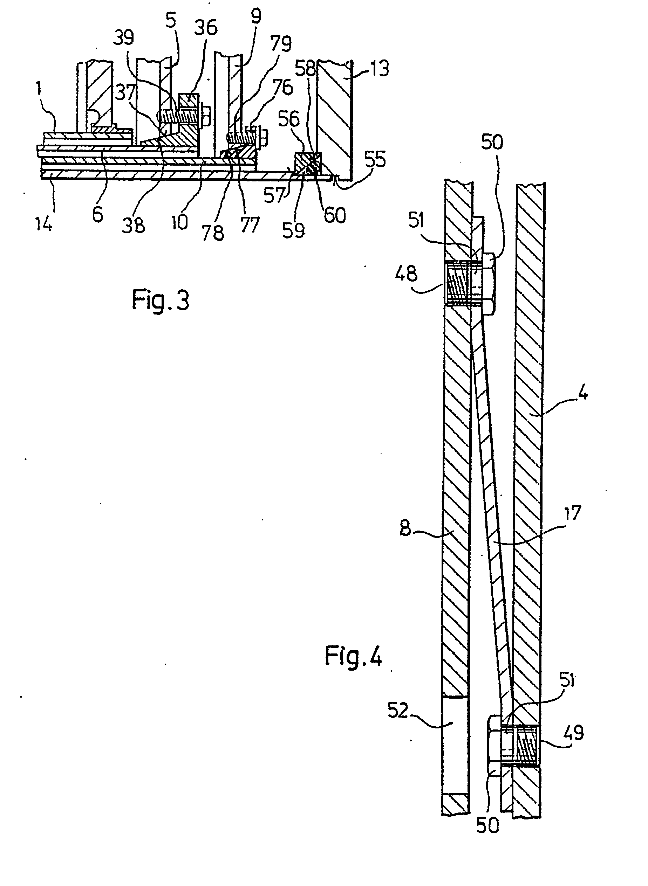

Nach dem Aufsetzen der einzelnen Bauteile wird jeweils der Deckel des äußeren Teiles bzw. die Endwand 12 des längeren Mantelteiles 20 mit dem Deckel des nächst inneren Teiles durch eine oder mehrere der in fig. 1 schematisch dargestellten Zugstäbe 17, 18 verbunden. Die Anordnung eines solchen Zugstabes 17 zwischen dem Deckel 8 des Stickstofftankes und dem Deckel 4 des Strahlungsschildes ist in Fig. 4 näher dargestellt. Bei dem Zugstab 17 handelt es sich um ein bandartiges Element, das aus einer mit Glasfasergewebe verstärkten Kunststoffplatte, insbesondere aus Epoxidharz, ausgeschnitten ist und in nicht näherdargestellter Weise an seinen Enden verbreitete Abschnitte mit Bohrungen zur Aufnahme von Befestigungsschrauben 48, 49 aufweist. Diese beiden Schrauben weisen jeweils im Anschluß an ihren Kopf 50 einen zylindrischen Abschnitt 51 auf, der als Lagerzapfen für den Zugstab 17 dient. Der Zugstab 17 ist auf den zylindrischen Abschnitten 51 schwenkbar und außerdem so verbiegbar, daß der Zugstab den Abstand zwischen den benachbarten Deckeln 4, 8 zu überbrücken vermag. Dabei lassen sich die Zugstäbe 17, 18 jeweils an der Innenseite eines Deckels befestigen, bevor das entsprechende Bauteil über das nächst innere gestülpt wird. Um dann das andere Ende des Zugstabes an der Außenseite des benachbarten Deckels zu befestigen, weist der jeweils äußere Deckel an der Stelle, an der das freie Ende des Zugstabes angeordnet ist, eine Aussparung 52 auf, die eine Montageöffnung bildet und es ermöglicht, die entsprechende Schraube 50 in die Bohrung am freien Ende des Zugstabes 17 einzuführen und auch in die Gewindebohrung des benachbarten Deckels 4 einzuschrauben.

Bei der Ausführungsform nach Fig. 1 sind Zugstäbe der beschriebenen Art zwischen dem Strahlungsschild 3 und dem Heliumtank 1 sowie zwischen den Deckeln des Stickstofftankes 7 und des Strahlungsschildes angeordnet. Die Befestigung des Stickstofftankes 7 am Mantel 11 können grundsätzlich in der gleichen Weise er folgen, auch wenn in Fig. 1 hierfür andere Befestigungselemente 21 herkömmlicher Art dargestellt sind. Außerdem sind bei dem dargestellten Ausführungsbeispiel in der Endwand 12 des längeren Mantelteiles 20 Transportsicherungen 22 angeordnet, die es in in nicht näher dargestellter Weise ermöglichen, eine starre Verbindung zwischen dem Heliumtank und dem mantel herzustellen. Nach dem Aufbringen des längeren Mantelteiles 20 ist es zweckmäßig, diese Transportsicherungen 22 in Eingriff zu bringen, bevor die Montage fortgesetzt wird.

Waren bisher die Bauteile mit vertikaler Achse auf einer Lehre montiert, ist es nun an der Zeit, die bisher montierten Teile von der Lehre zu entfernen und auf einem Gestell 100 mit horizontaler Achse zu befestigen. Nachdem dies geschehen ist, kann zunächst eine Verbindung zwischen dem an dem Strahlungsschild befestigten Kontaktrohr 34 und dem ersten Rohr 15 hergestellt werden, beispielsweise indem das Ende des Kontaktrohres 34 mit dem ersten Rohr 15 verlötet wird. Die dabei auftretende Wärme ist auf einen engen Raum begrenzt und führt nicht zur Beeinträchtigung anderer Bauteile, auch nicht einer eventuell bei der Montage der Bauteile zwischen diesen angeordneten Superisolierung. Danach wird ein weiteres Kontaktrohr 73 an einer Leiste 74 befestigt, die sich am Rand der Aussparung 71 im Stickstofftank 7 befindet. Auch dieses Kontaktrohr wird zuvor auf das erste Rohr 15 aufgeschoben und nach der Befestigung am Stickstofftank 7 an seinem freien Ende 75 mit dem ersten Rohr 15 verlötet. Anschließend werden dann die Deckel 5 und 9 auf die offenen Enden des Strahlungsschildes 3 bzw. des Stickstofftankes 7 aufgeschraubt. Ebenso werden die Verbindungen zu den zentralen Rohren 6 bzw. 10 hergestellt. Diese Rohre sind jeweils mittels eines Spannringes 36 bzw. 76 in einer entsprechenden zentralen Öffnung 37 bzw. 77 des zugeordneten Deckels 5 bezie hungsweise 9 befestigt, in welcher das jeweilige Ende des zentralen Rohres 6 bzw. 10 eingreift. Die Spannringe weisen jeweils einen kegelförmigen Ansatz 38 bzw. 78 auf, mit dem sie in die zentrale Öffnung 37 bzw. 77 eingreifen, so daß die mit einem Radialschlitz versehenen Spannringe verengt und damit an dem Umfang des zugeordneten Rohres 6 bzw. 10 angepreßt werden, wenn sie mit Hilfe von Spannschrauben 39 bzw. 79 gegen den jeweiligen Deckeln angezogen und dadurch gleichzeitig mittels des kegelförmigen Ansatzes 38 bzw. 78 in der Öffnung 37 bzw. 77 zentriert werden. Auf diese Weise ist eine sehr feste Verbindung zwischen den Deckeln und den zentralen Rohren möglich, durch die auch ein sehr guter Wärmekontakt gewährleistet wird, obwohl diese Verbindung bei Bedarf auch leicht wieder lösbar ist. Die gleiche Verbindung zwischen den zentralen Rohren und den Deckeln kann auch am anderen Ende der Bauteile verwendet werden, auch wenn es grundsätzlich möglich wäre, dort eine unlösbare Verbindung vorzusehen, beispielsweise die Rohre mit den Deckeln zu verschweißen, da diese Verbindung vor der Montage hergestellt und auch im Falle einer notwendigen Demontage nicht gelöst zu werden braucht.

Nachdem die Deckel an den Enden der Bauteile befestigt und die Verbindungen zu den zentralen Rohren hergestellt worden sind, können auch wieder die Deckel benachbarter Bauelemente mittels Zustäben in der bereits beschriebenen Weise miteinander verbunden werden. Danach wird dann das kurze Mantelteil 45 aufgesetzt, indem es in der in Fig. 5 angedeuteten Schräglage mit der in seiner Umfangsfläche vorgesehenen Öffnung 53 über das Rohr 15 mit dem äußeren Kontaktrohr 73 und das benachbarte zweite Rohr 16 geschoben und dann in Richtung des Pfeiles 54 eingeschwenkt wird, bis es mit seinem Flansch 42 am Flansch 41 des längeren Mantelteiles 20 zur Anlage kommt und mit diesem Flansch mittels der Spannschrauben 44 verbunden werden kann. Dabei kommt auch das Ende des zentralen Rohres 14 mit einer entsprechenden Öffnung 55 in der Endwand 13 des Mantelteiles 45 in Eingriff. Benachbart zur Innenseite der Endwand befindet sich auf dem Umfang des Rohres 14 ein Anschlagring 56, der an eine dem Ende des Rohres 14 zugewandten Schulter 57 Anlage findet. Dieser Anschlagring 56 hat den Querschnitt eines rechtwinkligen Dreiecks, dessen Hypotenuse 58 dem Ende und der Umfangsfläche des zentralen Rohres 14 zugewandt ist. Daher begrenzt dieser Anschlagring 56 zusammen mit der benachbarten Umfangsfläche des zentralen Rohres 14 und der angrenzenden Innenseite der Endwand 13 einen ebenfalls dreieckförmigen Hohlraum 59, in dem sich ein Dichtungsring 60 befindet. Auch hier kann wieder die Verbindung zwischen dem zentralen Rohr 14 und der anderen Endwand 12 des Mantels 11 in der gleichen Weise ausgebildet sein, obwohl am anderen Ende des Mantels auch eine unlösbare Verbindung zwischen der Endwand und dem zentralen Rohr möglich wäre. Bei der beschriebenen Verbindung an der in Fig. 1 rechten Endwand 13 werden keine zusätzlichen Befestigungselemente benötigt, weil nach dem Evakuieren des von dem Mantel 1 gebildeten Gehäuses die Endwand 13 vom Atmosphärendruck belastet wird, der bestrebt ist, die Endwand 13 nach innen zu drücken und dadurch die Innenwand fest an den Anschlagring 56 anpreßt, der sich seinerseits an der Schulter 57 am Umfang des zentralen Rohres 14 abstützt. Dadurch werden diese Teile nicht nur in einer definierten Lage gehalten, sondern es wird auch der sich in dem Hohlraum 59 befindende Dichtungsring 60 komprimiert, so daß er eine einwandfreie Abdichtung zwischen den genannten Bauteilen gewährleistet.

Nach der Montage des kurzen Mantelteiles 45 kann endlich die Montage des Turmes 19 erfolgen, der auf einen die Öffnung 53 umgebenden Ringflansch 61 aufgesetzt und mittels entsprechender Spann- und Dichtungselemente befestigt wird. Dieser Turm 19 ist an seinem oberen Ende durch eine Platte 62 verschlossen, mit der die Rohre 15 und 16 dicht verbunden, insbesondere verschweißt sind. Auch hier ist eine solche Verschweißung nicht störend, weil die Schweißstelle nur sehr kleine Abmessungen hat und ihre Herstellung keine große Wärmeentwicklung erfordert. Daher können die Schweißungen ohne Gefahr einer Beschädigung anderer Bauteile vorgenommen werden. Es lassen sich auch solche kleinen Schweißstellen leicht wieder auftrennen, so daß diese Schweißungen kein Hindernis für eine Demontage des Kryostaten bilden.

Wenn der Kryostat so weit fertiggestellt worden ist, kann er zum Einsatzort transportiert und dann nach Lösen der Transportsicherungen betriebsbereit gemacht werden, indem der vom Mantel umschlossene Raum evakuiert wird, die Kühlmittel eingefüllt werden und der Stromfluß in der supraleitenden Spule initiiert wird.

Die vorstehende Beschreibung hat deutlich gemacht, daß das dargestellte Ausführungsbeispiel aus einzelnen Bauteilen zusammengesetzt ist, die unabhängig voneinander vorgefertigt und dann in einer Weise miteinander verbunden werden können, die auch eine spätere Trennung dieser Bauteile wieder ermöglicht. Daher werden durch die Erfindung zwei bedeutende Ziele erreicht, nämlich einerseits eine vereinfachte Fertigung und andererseits eine leichte Demontierbarkeit zum Zwecke von Wartung und/oder Reparaturen.

## Patentansprüche

1. Kryostat, insbesondere für supraleitende Magnete, mit ineinander geschachtelten, horizontal angeordneten, rohrförmigen Bauelementen, die an ihren Enden durch Deckel verschlossen sind und mindestens einen inneren und einen äußeren Tank zur Aufnahme eines Kühlmittels, einen zwischen den Tanks angeordneten Strahlungsschild und einen den äußeren Tank umgebenden Mantel bilden, von denen der innere und der äußere Tank an ihrer Oberseite jeweils ein radial nach außen ragendes und die nach außen anschließenden Bauelemente durchdringendes erstes bzw. zweites Rohr aufweisen, welche Rohre an der Außenseite des Mantels von einem auf den Mantel aufgesetzten Turm umgeben sind, und mit die Bauteile verbindenden Zugelementen,
dadurch gekennzeichnet,
daß das erste Rohr (15) nahe einem Ende des inneren Tanks (1) angeordnet ist,
daß die zwischen dem inneren Tank (1) und dem Mantel (11) angeordneten Bauelemente (3,7) an dem Ende, an dem sich das erste Rohr (15) befindet, mit einem lösbaren Deckel (5 bzw. 9) versehen sind und eine bis zu diesem Ende des Bauelementes reichende Aussparung (31 bzw. 71) aufweisen, in die das erste Rohr (15) bei fehlendem Deckel vom Ende des Bauelementes her einführbar ist, daß das zweite Rohr (16) neben der Aussparung (71) des äußeren Tankes (7) angeordnet ist,

daß der Mantel (11) in einer den beiden Rohren (15,16) benachbarten Ebene, die sich an der dem Ende des Mantels (11) abgewandten Seite der Rohre (15,16) befindet, in einen längeren und einen kürzeren Abschnitt (20 bzw.45) unterteilt ist und der kürzere Abschnitt (45) in seiner Umfangsfläche eine Öffnung (53) für die dem Mantel (11) durchsetzenden Rohre (15,16) aufweist und

daß der die beiden Rohre umschließende Turm (19) längs des Randes der Öffnung (53) mit dem Mantel (11) verbunden ist.

2. Kryostat nach Anspruch 1, dadurch gekennzeichnet, daß auf die Aussparung (31,71) wenigstens eines der zwischen dem inneren Tank (1) und dem Mantel (11) angeordneten Bauelemente (3,7) ein Kontaktrohr (34,73) aufgesetzt ist, das mit wenigstens einem der diese Aussparung durchsetzenden Rohre (15) in Wärmekontakt steht.

3. Kryostat nach Anspruch 1 oder 2, dadurch gekennzeichnet, daß die lösbaren Deckel (5,9) mit den zugeordneten Bauelementen (3,7) und/oder die Abschnitte (20,45) des Mantels (11) miteinander verschraubt sind.

4. Kryostat nach einem der vorhergehenden Ansprüche, dadurch gekennzeichnet, daß die benachbarte Bauelemente (1,3,7) miteinander verbindenden Zugelemente (17,18) an der Außenseite des jeweils inneren Bauelementes (4) mittels Schrauben (49) befestigt sind, die durch in der Wandung (8) des jeweils äußeren Bauelementes angebrachte Ausparungen (52) hindurch von außen zugänglich sind.

5. Kryostat nach Anspruch 4, dadurch gekennzeichnet, daß die Zugelemente (17) aus mit Glasfasergewebe verstärkten bandartigen Elementen bestehen, die an ihren Enden mit Bohrungen für Befestigungsschrauben (48,49) versehene, verbreiterte Abschnitte aufweisen.

6. Kryostat nach Anspruch 4 oder 5, dadurch gekennzeichnet, daß die Schrauben (48,49) im Anschluß an ihren Kopf (50) einen am zugeordneten Bauelement anschlagenden zylindrischen Abschnitt (51) aufweisen, der als Lagerbolzen für den Zugstab (17) dient, auf dem der Zugstab mit Spiel schwenkbar gelagert ist.

7. Kryostat nach einem der vorhergehenden Ansprüche, dadurch gekennzeichnet, daß am Ende des längeren Abschnittes (20) des Mantels (11) eine Anordnung (22) zum Herstellen einer von außen lösbaren Verbindung zwischen dem Mantel (11) und wenigstens dem inneren Tank (1) angebracht ist.

8. Kryostat nach einem der vorhergehenden Ansprüche mit einem mit den Endwänden des Mantels verbundenen zentralen Rohr, das konzentrisch zu weiteren, mit den Deckeln der übrigen Bauteile verbundenen Rohre angeordnet ist, dadurch gekennzeichnet, daß die Deckel (5,9) der übrigen Bauteile (3,7) zentrale Öffnungen (37,77) aufweisen, in die die zugeordneten Rohre (6,10) mit ihren Enden eingreifen, und daß die Rohre mit den Deckeln durch geschlitzte Spannringe (36,76) verbunden sind, die in die in den Deckeln (5,9) angeordneten Öffnungen (37,77) mit einer Kegelfläche (38,78) eingreifen und die Rohre (6,10) mit einer Zylinderfläche umschließen.

9. Kryostat nach einem der vorhergehenden Ansprüche, dessen Mantel Endwände mit zentralen Öffnungen aufweist, die durch ein den vom Mantel umschlossenen Raum durchsetzendes Rohr miteinander verbunden sind, dadurch gekennzeichnet, daß das Rohr (14) mit wenigstens einem Ende in die Öffnungen (55) der Endwand (13) eingreift, im Abstand von den Innenseiten der Endwand (13) mit einem Anschlagring (56) versehen ist und zwischen dem Anschlagring (56) und der Endwand (13) ein Dichtungsring (60) angeordnet ist, derart, daß das zentrale Rohr (14) unter dem bei evakuiertem Mantel (11) auf dessen Endwände wirkende Luftdruck allein von den über den Dichtungsring (60) an die Anschlagringe angepreßte Endwände gehalten und abgedichtet wird.

10. Verfahren zum Montieren eines Kryostaten nach den vorhergehenden Ansprüchen, gekennzeichnet durch die folgenden Schritte:

a) Aufstellen des inneren Tankes (1) mit vertikaler Achse und nach unten offenem Ende auf eine Lehre,

b) Aufstellen des Strahlungsschildes (3) auf die Lehre in einer den inneren Tank (1) übergreifenden Lage und Montieren der den inneren Tank (1) mit dem Strahlungsschild (3) verbindenden Zugstäbe (18),

c) Montieren des das erste Rohr (15) umgebenden Kontaktrohres (34) am Strahlungsschild (31),

d) Aufstellen des äußeren Tankes (7) auf die Lehre in einer den Strahlungsschild (31) übergreifenden Lage und Montieren der den Strahlungsschild mit dem äußeren Tank (7) verbindenden Zugstäbe (17),

e) Aufstellen des größeren Abschnittes (20) des Mantels (11) auf die Lehre in einer den äußeren Tank (7) übergreifenden Lage und Montieren der den äußeren Tank mit dem Mantel (11) verbindenden Zugstäbe (21),

f) Herstellen der lösbaren Verbindung (22) zwischen dem Mantel (11) und dem inneren Tank (1) und Verschrauben des Mantels (11) mit der Lehre,

g) Überführen der bisher montierten Anordnung in die horizontale Lage und Befestigen an einem Ständer (100),

h) Herstellen eines Wärmekontaktes zwischen dem am Strahlungsschild (3) befestigten Kontaktrohr (34) und dem ersten Rohr (15),

i) Befestigen des Kontaktrohres (73) am äußeren Tank (7) und Herstellen eines Wärmekontaktes zwischen diesem Kontaktrohr (73) und dem ersten Rohr (15),

k) Montieren des Deckels (5) des Strahlungsschildes (3) und gegebenenfalls weiterer den inneren Tank mit dem Strahlungsschild verbindender Zugstäbe,

l) Montieren des Deckels (9) des äußeren Tanks (7) und gegebenenfalls weiterer, den Strahlungsschild mit dem äußeren Tank verbindender Zugstäbe,

m) Ansetzen des kleineren Abschnittes (45) des Mantels (11) unter gleichzeitigem Einführen der beiden Rohre (15,16) zusammen mit dem das erste Rohr (15) umgebenden, am äußeren Tank (7) befestigten Kontaktrohres (73) in die Öffnung (53) des kleineren Mantelteiles (45) und Verschrauben der Mantelteile (20,45) miteinander sowie gegebenenfalls Montieren weiterer, den äußeren Tank mit dem Mantel verbindender Zugstäbe,

n) Montieren des Turmes (19) an der Außenseite des Mantels (11) und Herstellen einer vakuumdichten Verbindung zwischen den Rohren (15,16) der beiden Tanks (1,7) und dem Turm (19) und o) Lösen der Verbindung (22) zwischen dem inneren Behälter (1) und dem Mantel (11).

11. Verfahren nach Anspruch 10, dadurch gekennzeichnet, daß die Wärmekontakte zwischen den Kontaktrohren (34,73) und dem ersten Rohr (15) durch Löten und die vakuumdichte Verbindung zwischen dem Turm (19) und dem ersten bzw. dem zweiten Rohr (15,16) durch Schweißen hergestellt werden.

## Claims

1. A cryostat, particularly for super-conductive magnets with inter-penetrative horizontally disposed tubular elements closed at their ends by covers and forming at least one inner and one outer tank to accommodate a cooling agent, a radiation shield disposed between the tanks and a casing enclosing the outer tank, of which the inner and outer tanks have on their top face in each case a radially outwardly projecting first and/or second tube which passes through the outwardly adjacent component elements, the said tubes being enclosed on the outside of the casing by a tower mounted on the casing, and comprising draw elements which connect the component parts, characterised in that the first tube (15) is disposed close to one end of the inner tank (1), and in that the component elements (3, 7) disposed between the inner tank (1) and the casing (11) are provided at the end at which the first tube (15) is disposed, with a separable cover (5, 9) and have, extending as far as this end of the component element a cut-out (31 or 71) into which it is possible to introduce the first tube (15) from the end of the component element, when the cover is removed, and in that the second tube (16) is disposed beside the cut-out (71) in the outer tank (7), and in that the casing (11) in a plane adjacent the two tubes (15, 16) which is disposed on the side of the tube (15, 16) remote from the end of the casing (11), is subdivided into a longer and a shorter portion (20, 45), the shorter portion (45) having in its peripheral surface an aperture (53) for the tubes (15, 16) traversing the casing (11) and in that the tower (19) which encloses the two tubes is connected to the casing (11) along the edge of the aperture (53).

2. A cryostat according to Claim 1, characterised in that mounted on the cut-out (31, 71) of at least one of the component elements (3, 7) disposed between the inner tank (1) and the casing (11), is a contact tube (34, 73) which is in heating contact with at least one of the tubes (15) traversing this cut-out.

3. A cryostat according to Claim 1 or 2, characterised in that the separable covers (5, 7) are screwed to the associated component (3, 7) and/or the portions (20, 45) of the casing (11) are screwed to one another.

4. A cryostat according to one of the preceding Claims, characterised in that the draw elements (17, 18) which connect the adjacent component elements (1, 3, 7) to one another are fixed on the outside of whichever is the inner component element (4) by means of screws (49) which are accessible from outside through cut-outs (52) provided in the walls (8) of whichever is the outer component element.

5. A cryostat according to Claim 4, characterised in that the draw elements (17) consist of glass fibre fabric reinforced strip-like elements which have at their ends widened portions in which there are bores to receive fixing screws (48, 49).

6. A cryostat according to Claim 4 or 5, characterised in that adjacent their heads (50), the screws (48, 49) have abutting the associated component element a cylindrical portion (51) which serves as a bearing bolt for the draw bar (17) and on which the draw bar is mounted to pivot with clearance.

7. A cryostat according to one of the preceding Claims, characterised in that at the end of the longer portion (20) of the casing (11) there is an arrangement (22) for producing between the casing (11) and at least the inner tank (1) a connection which can be separated from outside.

8. A cryostat according to one of the preceding Claims with, connected to the end walls of the casing, a central tube which is disposed concentrically with ether tubes connected to the covers on the other component elements, characterised in that the covers (5, 9) of the other components (3, 7) have central apertures (37, 77) engaged by the ends of the associated tubes (6, 10) and in that the tubes with the covers are joined by slotted clamping rings (36, 76) which have a bevelled surface (38, 78) which engages apertures (37, 77) disposed in the covers (5, 9), and having a cylindrical face which enclose the tubes (6, 10).

9. A cryostat according to one of the preceding Claims and of which the casing comprises end walls with central apertures which are connected to one another by a tube traversing the space enclosed by the casing, characterised in that the tube (14) has at least one end which engages the apertures (55) in the end wall, (13) and is provided at a distance from the inside faces of the end wall (13) with an abutment ring (56) and in that there is between the abutment ring (56) and the end wall (13) a packing ring (60) so that the central tube (14) is sealed and held solely by the end walls pressed against the abutment rings via the packing ring (60) by the air pressure acting on the said end walls when the casing (11) is evacuated.

10. A method of mounting a cryostat according to the preceding Claims, characterised by the following steps:

a) Setting up of the inner tank (1) with a vertical axis and with the open end pointing downwards, on a gauge,

b) mounting of the radiation shield (3) on the gauge in a position in which it engages over the inner tank (1) and mounting of the draw bars (18) which connect the inner tank (1) to the radiation shield (3),

c) mounting on the radiation shield (31) of the contact tube (34) which encloses the first tube (15),

d) setting up of the outer tank (7) on the gauge in a position in which it engages over the radiation shield (31) and mounting of the draw bars (17) which connect the radiation shield to the outer tank (7),

e) mounting of the larger portion (20) of the casing (11) on the gauge in a position in which it engages over the outer tank (7) and mounting of the draw bars (21) which connect the outer tank to the casing (11),

f) establishment of the separable connection (22) between the casing (11) and the inner tank (1) and screwing of the casing (11) to the gauge,

g) transferring the arrangement so far assembled into the horizontal position and fixing it on a stand (100),

h) establishment of a heat contact between the contact tube (14) mounted on the radiation shield (3) and the first tube (15),

i) fixing of the contact tube (73) on the outer tank (7) and establishment of a heating contact between this contact tube (73) and the first tube (15), k) fitting of the cover (5) of the radiation shield (3) and possibly further draw bars which connect the inner tank to the radiation shield,

l) mounting of the cover (9) of the outer tank (7) and possibly further draw bars connecting the radiation shield to the outer tank,

m) fitment of the smaller portion (45) of the casing (11) while at the same time introducing the two tubes (15, 16) together with the contact tube (73) fixed on the outer tank (7) and enclosing the first tube (15) into the aperture (53) of the smaller casing part (45) and screwing the casing parts (20, 45) together and also possibly fitting further draw bars connecting the outer tank to the casing,

n) fitting the tower (19) on the outside of the casing (11) and establishment of a vacuum tight connection between the tubes (15, 16) of the two tanks (1, 7) and the tower (19) and

o) undoing the connection (22) between the inner container (1) and the casing (11).

11. A method according to Claim 10, characterised in that the heating contacts between the contact tubes (34, 73) and the first tube (15) are made by soldering while the vacuum tight connection between the tower (19) and the first or the second tube (15, 16) is made by welding.

## Revendications

1. Cryostat, en particulier pour aimants supraconducteurs, du type comportant des pièces constitutives tubulaires, imbriquées les unes dans les autres en disposition horizontale, qui sont obturées à leurs extrémités par des couvercles et qui forment au moins un réservoir intérieur et un réservoir extérieur pour la réception d'un fluide frigorigène, un bouclier de rayonnement entre les deux réservoirs et une enveloppe entourant le réservoir extérieur, le réservoir intérieur et le réservoir extérieur présentant chacun, à leur côté supérieur, un premier ou respectivement un second tube, en extension radiale vers l'extérieur et traversant les pièces constitutives s'étendant vers l'extérieur, lesdits tubes étant, du côté extérieur de l'enveloppe, entourés d'une tour montée sur l'enveloppe, et des éléments de traction reliant les pièces constitutives, caractérisé en ce que le premier tube (15) est disposé à proximité d'une extrémité du premier réservoir (1), en ce que les pièces constitutives (3, 7) disposées entre le réservoir intérieur (1) et l'enveloppe (11) sont, à l'extrémité où se trouve le premier tube (15), pourvues d'un couvercle amovible (5, 9) et présentent un évidement (31, 71) qui atteint cette extrémité de pièce constitutive et dans lequel le premier tube (15) peut être introduit à partir de cette extrémité de pièce constitutive dans le cas d'absence de couvercle, en ce que le deuxième tube (16) est disposé à proximité de l'évidement (71) du réservoir extérieur (7), en ce que l'enveloppe (11) est divisée en un tronçon long (20) et en un tronçon court (45) dans un plan voisin des deux tubes (15, 16), plan se trouvant du côté des tubes (15, 16) situé à l'opposé de l'extrémité de l'enveloppe, le tronçon court (45) présentant dans sa surface périphérique une ouverture (53) pour les tubes (15, 16) traversant l'enveloppe (11), et en ce que la tour (19) entourant les deux tubes est reliée à l'enveloppe (11) le long du bord de l'ouverture (53).

2. Cryostat selon la revendication 1, caractérisé en ce que sur l'évidement (31, 71) d'au moins une des pièces constitutives (3, 7) situées entre le réservoir intérieur (1) et l'enveloppe (11), est monté un tube de contact (34, 73) placé en contact thermique avec au moins un des tubes (15) traversant cet évidement.

3. Cryostat selon les revendications 1 ou 2, caractérisé en ce que les couvercles démontables (5, 9) sont vissés sur les pièces constitutives correspondantes (3, 7) et/ou en ce que les tronçons (20, 45) de l'enveloppe (11) sont vissés l'un à l'autre.

4. Cryostat selon l'une des revendications précédentes, caractérisé en ce que les éléments de traction (17, 18) reliant des pièces constitutives voisines (1, 3, 7) sont fixés par des vis (49) sur la face extérieure de la pièce constitutive respectivement intérieure (4), vis qui sont accessibles à partir de l'extérieur, par des évidements (52) ménagés dans la paroi (8) de la pièce constitutive respectivement extérieure.

5. Cryostat selon la revendication 4, caractérisé en ce que les éléments de traction (17) sont constitués d'éléments de type bandes qui sont renforcées de tissu en fibre de verre et qui présentent à leurs extrémités des sections élargies, pourvues d'ouvertures pour des vis de fixation (48, 49).

6. Cryostat selon la revendication 4 ou 5, caractérisé en ce que les vis (48, 49) présentent, raccordé à leur tête (50), un tronçon cylindrique (51) de butée pour la pièce constitutive correspondante qui sert, pour l'élément de traction (17), de boulon d'appui sur lequel l'élément de traction est monté avec du jeu de manière à pouvoir pivoter.

7. Cryostat selon l'une des revendications précédentes, caractérisé en ce qu'à l'extrémité du tronçon long (20) de l'enveloppe (11) est prévu un ensemble (22) destiné à former un raccord detachable de l'extérieur entre l'enveloppe (11) et au moins le réservoir intérieur (1).

8. Cryostat selon l'une des revendications précédentes, comprenant un tube central, relié aux parois d'extrémité de l'enveloppe et agencé concentriquement à d'autres tubes reliés aux couvercles des pièces constitutives restantes, caractérisé en ce que les couvercles (5, 9) des pièces constitutives restantes (3, 7) présentent des ouvertures centrales (37, 77), ouvertures dans lesquelles les tubes correspondants (6, 10) pénètrent par leurs extrémités et en ce que les tubes sont raccordés aux couvercles au moyen de colliers de serrage fendus (36, 76) qui s'engagent dans les ouvertures (37, 77), prévues dans les couvercles (5, 9), par une surface conique (38, 78) et qui entourent les tubes (6, 10) d'une surface cylindrique.

9. Cryostat selon l'une des revendications précédentes dont l'enveloppe présente des parois d'extrémité à ouvertures centrales qui sont reliées mutuellement par un tube traversant l'espace renfermé par l'enveloppe, caractérisé en ce que le tube (14) est, par au moins une des extrémités, en prise avec les ouvertures (55) de la paroi d'extrémité (13), et est pourvu d'une bague de butée (56) à distance des côtés intérieurs de la paroi d'extrémité (13) et en ce que, entre la bague de butée (56) et la paroi d'extrémité (13), est interposé un joint annulaire d'étanchéité (60), de façon que, sous la pression d'air agissant sur les parois d'extrémité de l'enveloppe (11), lorsque celle-ci est mise sous vide, le tube central (14) soit maintenu et rendu étanche seulement par les parois d'extrémité appliquées contre les bagues de butée par l'intermédiaire du joint annulaire (60).

10. Procédé de montage d'un cryostat selon les revendications précédentes, caractérisé par les étapes suivantes:

a) Mise en position du réservoir intérieur (1) selon un axe vertical sur un gabarit avec disposition de l'extrémité ouverte vers le bas.

b) Mise en place du bouclier de rayonnement (3) sur le gabarit dans une position recouvrant le réservoir intérieur (1) et montage des éléments de traction (18) reliant le bouclier de rayonnement (3) au réservoir intérieur (1).

c) Montage du tube de contact (34) entourant le premier tube (15) sur le bouclier de rayonnement (31).

d) Mise en place du réservoir extérieur (7) sur le gabarit dans une position recouvrant le bouclier de rayonnement (31) et montage des éléments de traction (17) reliant le bouclier de rayonnement (31) au réservoir extérieur (7).

e) Mise en position du grand tronçon (20) de l'enveloppe (11) sur le gabarit dans une position recouvrant le réservoir extérieur (7) et montage des éléments de traction (21) reliant l'enveloppe (11) au réservoir extérieur.

f) Exécution de la liaison amovible (22) entre l'enveloppe (11) et le réservoir intérieur (1) et fixation de l'enveloppe (11) au gabarit par vissage.

g) Transfert de l'ensemble monté précédemment dans la position horizontale et fixation à un poteau-support (100).

h) Réalisation d'un contact thermique entre le tube de contact (34) fixé au bouclier de rayonnement (3) et le premier tube (15).

i) Fixation du tube de contact (73) au réservoir extérieur (7) et réalisation d'un contact thermique entre ce tube de contact (73) et le premier tube (15).

k) Montage du couvercle (5) du bouclier de rayonnement (3) et, le cas échéant, d'autres éléments de traction reliant le réservoir intérieur au bouclier de rayonnement.

l) Montage du couvercle (9) du réservoir extérieur (7) et, le cas échéant, d'autres éléments de traction reliant le bouclier de rayonnement au réservoir extérieur.

m) Montage du tronçon court (45) de l'enveloppe (11) en introduisant simultanément dans l'ouverture (53) du tronçon court les deux tubes (15, 16) avec le tube de contact (73) qui entoure le premier tube (15) et qui est fixé au réservoir extérieur (7), et réunion par vissage des tronçons d'enveloppe (20 et 45) entre eux ainsi que le cas échéant, montage d'autres éléments de traction reliant le réservoir extérieur à l'enveloppe.

n) Montage de la tour (19) du côté extérieur de l'enveloppe (11) et réalisation d'une liaison étanche en dépression entre les tubes (15, 16) des deux réservoirs (1, 7) et la tour (19) et,

o) Suppression de la liaison (22) entre le réservoir intérieur (1) et l'enveloppe (11).

11. Procédé selon la revendication 10, caractérisé en ce que les contacts thermiques entre les tubes de contact (34, 73) et le premier tube (15) sont réalisés par brasage et en ce que la liaison étanche en dépression entre la tour (19) et le premier ou deuxième tube (15, 16) est réalisée par soudage.

Fig.1

Fig.2

Fig. 3

Fig. 4

Fig. 5

EP 0 301 306 B1